# EUROPÄISCHE PATENTSCHRIFT

(11) **EP 0 641 086 B1**
(45) Veröffentlichungstag und Bekanntmachung des Hinweises auf die Patenterteilung: **29.09.1999**
(21) Anmeldenummer: 94111538.8
(22) Anmeldetag: 23.07.1994
(51) Int. Cl.: H03M 11/24

(54) **Einrichtung zur Abfrage von Bedienelementen**
Device for the interrogation of control elements
Dispositif d'interrogation d'éléments de commande

(30) Priorität: 26.08.1993 DE 4328663
(43) Veröffentlichungstag der Anmeldung: 01.03.1995
(73) Patentinhaber: GRUNDIG Aktiengesellschaft, 90762 Fürth (DE)
(72) Erfinder: Ritter, Kai-Uwe, Grundig E.M.V., D-90748 Fürth (DE)

(56) Entgegenhaltungen:
- WO-A-94/19736
- DE-A- 3 805 593
- JP-A- 40 068 417
- JP-A- 58 052 729
- US-A- 3 765 015
- PATENT ABSTRACTS OF JAPAN vol. 18, no. 42 (P-1680) 21. Januar 1994 & JP-A-52 066 218 (FUJITSU) 15. Oktober 1993
- PATENT ABSTRACTS OF JAPAN vol. 7, no. 138 (P-204) 16. Juni 1983 & JP-A-58 052 729 (EPUSON) 29. März 1983
- PATENT ABSTRACTS OF JAPAN vol. 16, no. 268 (P-1372) 17. Juni 1992 & JP-A-40 068 417 (SONY) 4. März 1992
- MOTOROLA TECHNICAL DEVELOPMENTS, Bd.20, Oktober 1993, SCHAUMBURG, ILL, US Seiten 108 - 109, XP000403840 RÖTZER ET AL 'use of an a-d converter in a microcontroller for key decoding'

## Beschreibung

Die Erfindung betrifft eine Einrichtung nach dem Oberbegriff des Patentanspruchs 1.

Zur Steuerung von elektronischen Geräten, insbesondere nachrichtentechnischen Geräten, wie beispielsweise Autoradios, werden häufig Mikroprozessoren verwendet. Diese fragen die Stellung mehrerer Bedienelemente ab und steuern in dem Gerät vorgesehene Stellglieder entsprechend. Aus der EP-A1-0 533 098 ist ein derartiges Gerät in Form eines Autoradios bekannt. Die Eingaben in das Autoradio werden dabei in automatische und manuelle unterteilt. Die Bedienelemente für manuelle Eingaben werden in kurzen Zeitabständen durch einen Mikroprozessor abgefragt, automatische Eingaben lösen einen Interrupt im Programm dieses Mikroprozessors aus.

Von Nachteil bei einer derartigen Abfrage ist, daß der Mikroprozessor die Bedienelemente sehr häufig auf eine Aktivierung hin überprüfen muß, um eine Verarbeitung der Eingaben in Echtzeit zu gewährleisten (Polling). Dafür wird, auch wenn kein Bedienelement betätigt wurde, viel Prozessorleistung benötigt. Ein weiterer Nachteil liegt in der großen Anzahl von Verbindungsleitungen zwischen den Bedienelementen und dem Mikroprozessor, die einen erheblichen Verdrahtungsaufwand zur Folge haben.

Aus der DE-A1-39 37 140 ist eine Schaltungsanordnung zur Abfrage des Bedienungszustandes von Funktionstasten bekannt. Bei Betätigung einer Funktionstaste werden die in Zeilen und Spalten angeordneten Abfrageleitungen leitend verbunden. Zusätzlich besteht über eine Diode eine Verbindung zwischen je einer Spaltenleitung und einer Zeilenleitung. Während der Abfrage durch einen Mikroprozessor wird über die Abfrageleitungen nacheinander während einer bestimmten Zeitdauer ein Signal ausgegeben und die übrigen Abfrageleitungen während dieser Zeitdauer abgefragt.

Von Nachteil ist hierbei, daß immer noch eine große Anzahl Verbindungsleitungen zwischen Mikroprozessor und Funktionstasten vorhanden ist. Ein weiterer Nachteil liegt in der zeitaufwendigen Überprüfung der Abfrageleitungen, ob ein Signal vorliegt.

Beim Gegenstand der EP-B1-0 123 715 ist eine Einrichtung zur Tastenabfrage von Funktionstasten bekannt. Bei dieser Einrichtung wird ein für die betätigte Taste charakteristischer Spannungsabfall an einem stromgespeisten Widerstandsnetzwerk hervorgerufen. Dieser Spannungsabfall wird durch einen Analog-Digital-Umsetzer in ein digitales Signal umgesetzt und durch eine Auswerteeinrichtung ausgewertet. Hierbei wird erst bei Betätigung einer Taste die Spannungsversorgungsquelle mit dem Gerät verbunden.

Von Nachteil ist hierbei, daß die Abfrage der Tasten nicht interruptgesteuert erfolgen kann, sondern ein Polling der Tasten durchgeführt werden muß, so lange eine Funktion des Geräts aktiv ist. Dies beruht darauf, daß die Amplitude des Eingangssignals für den Analog-Digital-Umsetzer zu gering sein kann, um einen Interrupt auszulösen. Ein weiterer Nachteil besteht in der begrenzten Anzahl von Funktionstasten, die unter Berücksichtigung von Temperaturdriften und Bauteiltoleranzen an einen Analog-Digital-Umsetzer aufgrund dessen Auflösung angeschlossen werden können.

Weiterhin können durch das häufige Ein- und Ausschalten der Spannungsversorgung hochfrequente Störungen entstehen.

Aus der DE-C2-36 24 716 ist ein Auto-Rundfunkgerät mit abnehmbarem Bedienteil bekannt. Das abnehmbare Bedienteil nimmt dabei einen wesentlichen Teil der Frontseite des Auto-Rundfunkgeräts ein und weist eine Vielzahl Bedienelemente auf. Dadurch ist es erforderlich, Kontaktstellen an Bedien- und Hauptteil vorzusehen, um die Eingaben vom Bedienteil zum Hauptteil weiterleiten zu können. Da an diesen Kontaktstellen mechanische Abnutzung und Korrosion auftreten kann, ist es wünschenswert, wenn möglichst wenig Kontaktstellen benötigt werden.

Aus der US 4,555,693 ist eine Tastatur für einen Computer mit einer Vielzahl von Tasten bekannt. Bei Betätigung einer Taste werden die in Zeilen und Spalten angeordneten Abfrageleitungen mit einer Strom- oder Spannungsquelle verbunden. Darüberhinaus ist jede Zeilenleitung, ebenso wie jede Spaltenleitung, über einen charakteristischen Widerstand mit einem Analog-Digital-Umsetzer verbunden. Dadurch kann aufgrund der digitalen Ausgabedaten der Analog-Digital-Umsetzer das Betätigen einer Taste von einem Mikroprozessor erkannt werden.

Hierbei ist von Nachteil, daß die Ausgabedaten der Analog-Digital-Umsetzer in kurzen und regelmäßigen Zeitabständen abgefragt werden (Polling), was viel Prozessorleistung benötigt. Es erfolgt keine interruptgesteuerte Tastaturabfrage. Zudem werden zwei Analog-Digital-Umsetzer benötigt, um die Signale der Zeilen- und Spaltenleitung umzusetzen.

Aus DE 38 05 593 A1 ist eine weitere Tasteneingabevorrichtung bekannt. Auch bei dieser Vorrichtung weist jeder Widerstand, der mit einem Schalter gekoppelt ist, einen definierten Widerstandswert auf (vgl. Tabelle 2, Seite 4).

Aus US 3 765 015 A ist eine Überwachungseinrichtung zur Überwachung und Erkennung der Zustände von Schaltern 10 bekannt. Jeder Schalter 10 ist mit einem Widerstand 11 in Reihe geschaltet und die Schalter 10 zusammen mit den Widerständen 11 sind parallelgeschaltet. Über einen Widerstand 13 wird eine Referenzspannung Vref angelegt. Ein Detektor 14 ist vorgesehen, welchem die Spannung Vin zugeführt wird. Im weiteren ist eine Encoder 16 vorgesehen.

Der Erfindung liegt daher die Aufgabe zugrunde, sowohl die Anzahl der Verbindungsleitungen zwischen Bedienelementen und zugehöriger Steuereinheit, als auch die Anzahl der Tastaturabfragen durch die Steuereinheit und die Anzahl der benötigten Baugruppen zu minimieren.

Diese Aufgabe wird bei der erfindungsgemäßen Einrichtung durch die im Patentanspruch 1 gekennzeichneten Merkmale gelöst.

Die erfindungsgemäße Einrichtung weist den Vorteil auf, daß eine Abfrage der Bedienelemente erst dann durchgeführt wird, wenn ein Bedienelement betätigt wurde. Weiterhin von Vorteil ist, daß die Bedienelemente, insbesondere Tasten, analoge Signale zur Auswertung übertragen, wodurch nur eine minimale Anzahl Verbindungsleitungen zwischen Bedienelementen und Steuereinheit einschließlich Analog-Digital-Umsetzer benötigt wird. Durch diese Vorteile werden zudem Störungen, die durch häufige Tastaturabfragen entstehen (Polling) verringert. Weiterhin von Vorteil ist die besonders einfache Erzeugung eines Steuersignals durch eine Signalformung. Ein weiterer Vorteil besteht darin, daß mehrere Gruppen Bedienelemente mit nachfolgendem Signalformer zur Erhöhung der Anzahl Bedienelemente parallel geschaltet werden können. Dabei wird nur ein Analog-Digital-Umsetzer benötigt, um die analogen Eingangssignale mehrerer Gruppen Bedienelemente für die Steuereinheit umzusetzen. Dadurch kann eine erhebliche Kostenersparnis erzielt werden.

Die erfindungsgemäße Einrichtung nach Anspruch 2 weist den Vorteil auf, daß der Verdrahtungsaufwand wesentlich verringert werden kann und auch die elektrischen Verbindungen zwischen Bedien- und Hauptteil durch eine entsprechende Aufteilung der Baugruppen vereinfacht werden. Außerdem nimmt durch die Verringerung der Leitungsanzahl die Störanfälligkeit ab.

Die erfindungsgemäße Einrichtung nach Anspruch 3 weist den Vorteil auf, daß ein Mikroprozessor mit Interrupteingang und Analog-Digital-Umsetzer eine besonders einfache und kostengünstige Möglichkeit darstellt, die Bedienelemente interruptgesteuert abzufragen.

Die erfindungsgemäße Einrichtung nach Anspruch 4 weist den Vorteil auf, daß der Signalformer durch einen Komparator, einen Schmitt-Trigger oder einen Transistor sehr einfach realisiert werden kann.

Die Erfindung wird im folgenden anhand in der Zeichnung dargestellter Ausführungsbeispiele näher beschrieben und erläutert. Es zeigt:
- Fig. 1: ein Ausführungsbeispiel für die erfindungsgemäße Steuerung der Tastaturabfrage bei einer großen Anzahl Tasten und
- Fig. 2: ein Ausführungsbeispiel für eine interruptgesteuerte Tastaturabfrage.

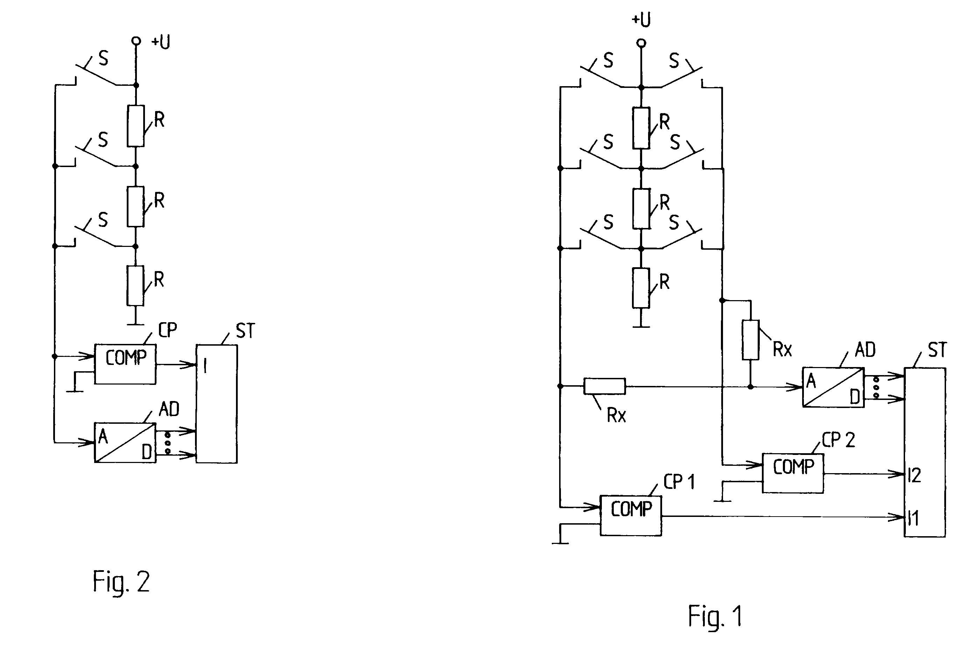

Fig. 2 zeigt eine Serienschaltung aus mehreren Widerständen R, die einen Spannungsteiler bilden. Durch Bedienelemente S, z.B. Tasten eines Autoradio-Bedienteils, kann eine für jedes Bedienelement S charakteristische Spannung des Spannungsteilers ausgewählt werden, die an einen Analog-Digital-Umsetzer AD weitergeleitet wird. Das Ausgangssignal des Analog-Digital-Umsetzers AD wird an eine Steuereinheit ST weitergeleitet, die das betätigte Bedienelement S erkennt und eine dem erkannten Bedienelement S entsprechende Funktion durchführt.

Außerdem wird die durch das betätigte Bedienelement S ausgewählte charakteristische Spannung des Spannungsteilers einer Signalformung CP zugeleitet. Die Signalformung CP formt das Ausgangssignal der Bedienelemente S derart, daß ein von der Steuereinheit ST benötigtes Eingangssignal vorliegt.

Eine derartige Signalformung kann beispielsweise durch einen Komparator, der einen Vergleich mit einem Bezugspegel durchführt und bei Vorliegen einer entsprechenden Eingangsamplitude ein binäres Signal ausgibt, oder durch einen Schmitt-Trigger erfolgen, der bei einem Eingangssignal mit einer Mindestamplitude ein Ausgangssignal mit einer bestimmten Amplitude ausgibt. Der Bezugspegel bzw. die Mindestamplitude ist dabei so zu wählen, daß auch bei der niedrigsten Spannung des Spannungsteilers noch ein Ausgangssignal von der Signalformung CP ausgegeben wird. Besonders einfach und kostensparend kann die Signalformung CP durch einen Transistor realisiert werden, dessen Basisanschluß das Eingangssignal des Analog-Digital-Umsetzers AD zugeführt wird und der den Interrupt-Eingang I der Steuereinheit ST mit dem erforderlichen Interruptsignal versorgt.

Das Ausgangssignal der Signalformung CP wird einem Interrupt-Eingang I der Steuereinheit ST zugeleitet. Sobald ein Eingangssignal an diesem Eingang I anliegt, wird die Steuereinheit ST dazu veranlaßt, das Ausgangssignal des Analog-Digital-Umsetzers AD auszuwerten. Dadurch kann vermieden werden, daß die Steuereinheit ST regelmäßig überprüfen muß, ob ein Signal vom Analog-Digital-Umsetzer AD ausgegeben wird (Polling).

In der Figur 2 sind lediglich drei Bedienelemente S, die drei charakteristische Ausgangsspannungen aufweisen, über eine Leitung mit dem Analog-Digital-Umsetzer AD verbunden. Um diese drei Ausgangsspannungen in digitale Signale umzusetzen, die von der Steuereinheit ST weiter verarbeitet werden können, ist ein Analog-Digital-Umsetzer AD für mindestens zwei Bit Breite der Ausgabedaten erforderlich. Sollen mehrere Bedienelemente S über eine Leitung mit dem Analog-Digital-Umsetzer AD verbunden werden, ist eine entsprechende Breite der Ausgabedaten zu wählen. Außerdem ist die maximale Eingangsspannung +U des Analog-Digital-Umsetzers AD so zu wählen, daß sie mit dessen Aussteuerungsgrenze übereinstimmt.

Die Figur 1 zeigt eine Realisierungsmöglichkeit für die Abfragesteuerung sehr vieler Bedienelemente S. Sind so viele Bedienelemente S vorhanden, daß ein Analog-Digital-Umsetzer AD mit der erforderlichen Breite der Ausgabedaten nicht zur Verfügung steht oder zu teuer wäre, besteht die Möglichkeit, die Bedienelemente S in mehrere Gruppen zu unterteilen.

Fig. 1 zeigt zwei Bedienelementegruppen, die mit einem Spannungsteiler verbunden sind. Alternativ ist auch die Verwendung zweier Spannungsteiler möglich, wobei die charakteristischen Spannungen für die Bedienelemente S unterschiedlicher Gruppen unterschiedlich sein können. Dies wird dadurch erreicht, daß die Widerstände R der Spannungsteiler unterschiedliche Werte haben. Dadurch können gleichzeitige Betätigungen von Bedienelementen S erkannt werden. Das Ausgangssignal jeder Gruppe Bedienelemente S wird dabei über einen Widerstand Rx dem Eingang des Analog-Digital-Umsetzers AD zugeleitet, der es umsetzt und an die Steuereinheit ST zur Auswertung weiterleitet. Zusätzlich wird das Ausgangssignal jeder Gruppe Bedienelemente S je einem Signalformer CP1 bzw. CP2 zugeleitet. Jedes Ausgangssignal eines Signalformers CP1 oder CP2 wird wiederum jeweils einem Interrupt-Eingang I1 oder I2 der Steuereinheit ST zugeleitet, woran diese erkennen kann, aus welcher Gruppe ein Bedienelement S oder ob in mehreren Gruppen ein Bedienelement S betätigt wurde. Die Verwendung der Widerstände Rx ist erforderlich, da ansonsten die Eingänge der beiden Signalformer CP1 und CP2 kurzgeschlossen wären. Daraus ergibt sich die Dimensionierung der Widerstände Rx. Es muß gewährleistet sein, daß an einem der beiden Signalformer die maximal mögliche Spannung +U anliegt, ohne daß der andere Signalformer ein Signal ausgibt. Weiterhin ist es vorteilhaft, beide Widerstände Rx gleich zu dimensionieren, um den Auflösungsbereich des Analog-Digital-Umsetzers AD voll auszunutzen.

Der Analog-Digital-Umsetzer AD kann alternativ auch über in Durchlaßrichtung gepolte Dioden von den zwei oder mehreren Bedienelementegruppen angesteuert werden. Diese Dioden verhindern durch ihre Sperrwirkung in umgekehrter Richtung, daß das Signal einer ersten Bedienelementegruppe den nicht zugehörigen Signalformern der anderen Bedienelementegruppen zugeführt wird..

Als Eingänge I1 und I2 werden vorzugsweise Interrupt-Eingänge verwendet, bei denen ein Signal eine Unterbrechung des von der Steuereinheit ST bis dahin abgearbeiteten Programmablaufs und eine Abarbeitung einer Interrupt-Routine zur Folge hat. Werden Ein-/Ausgabe Anschlüsse verwendet, müssen diese zwar weiterhin in kurzen Zeitabständen abgefragt werden, die Anzahl der abzufragenden Ein-/Ausgabe Anschlüsse kann jedoch wesentlich reduziert werden.

Die beschriebene Einrichtung zur Abfrage von Bedienelementen S kann selbstverständlich überall dort eingesetzt werden, wo analoge Spannungen, welche eine unmittelbare Interruptsteuerung nicht ermöglichen, zur Informationsübertragung genutzt werden.

## Patentansprüche

1. Einrichtung zur Abfrage von Bedienelementen (S) eines elektrischen Gerätes, welche zu Bedienelementegruppen zusammengefaßt sind, wobei durch Betätigung eines Bedienelements (S) an einem Widerstandsnetzwerk (R) jeweils ein für das betätigte Bedienelement (S) einer Bedienelementegruppe charakteristisches Signal in Form eines Spannungsabfalls hervorgerufen wird, welcher durch einen Analog-Digital-Umsetzer (AD) quantifiziert und durch eine Steuereinheit (ST) ausgewertet wird und durch die Bedienelemente (S) jeder Bedienelementegruppe hervorgerutene Signal an einen Signalformer (CP1, CP2) angelegt wird, die Signale der Bedienelementegruppen dem Analog-Digital-Umsetzers (AD) über jeweils einen Widerstand (Rx), eine Diode oder einen Spannungsteiler zugeleitet werden
**dadurch gekennzeichnet,**
daß Ausgangssignale der Signalformer (CP1, CP2) jeweils einem Eingang (11, 12) der Steuereinheit (ST) zugeleitet werden, daß Widerstandsnetzwerke (R) und Bedienelemente (S) in einem Bedienteil und Steuereinheit (ST), Analog-Digital-Umsetzer (AD) und Signalformer (CP) in einem Hauptteil des elektrischen Geräts angeordnet sind, wodurch eine minimale Anzahl von Verbindungsleitungen zwischen Bedien- und Hauptteil erforderlich ist und daß die Widerstandswerte der Widerstände des Widerstandsnetzwerkes (R) gleichohmig sind.

2. Einrichtung nach Anspruch 1,
**dadurch gekennzeichnet,**
daß als Steuereinheit (ST) ein Mikroprozessor mit mindestens einem Interrupt-Eingang (1) und mindestens einem integrierten Analog-Digital-Umsetzer (AD) vorgesehen ist.

3. Einrichtung nach Anspruch 1 oder 2,
**dadurch gekennzeichnet,**
daß als Signalformer (CP) Komparatoren, Transistoren oder Schmitt-Trigger eingesetzt werden.

## Claims

1. Device for the interrogation of operating elements (S) of an electrical appliance which are combined to form operating element groups, in which, as the result of actuating an operating element (S), a characteristic signal in the form of a voltage drop is produced across a resistor network (R) for each of the operating elements (S) actuated in an operating element group, which voltage drop is quantified by an analogue/digital converter (AD) and is evaluated by a control unit (ST), and the signal produced by the operating elements (S) of each operating element group is applied to a signal shaper (CP1, CP2) and the signals of the operating element groups are fed to the analogue/digital converter (AD) via a resistor (Rx), a diode or a voltage divider in each case, characterized in that the output signals of the signal shapers (CP1, CP2) are each fed to an input (I1, I2) of the control unit (ST), in that resistor networks (R) and operating elements (S) are disposed in an operating section and the control unit (ST), the analogue/digital converter (AD) and the signal shaper (CP) are disposed in a main section of the electrical appliance, as a result of which a minimum number of connecting lines between operating section and main section is necessary, and in that the resistance values of the resistors of the resistor network (R) have the same ohmic value.

2. Device according to Claim 1, characterized in that a microprocessor having at least one interrupt input (I) and at least one integrated analogue/digital converter (AD) is provided as control unit (ST).

3. Device according to Claim 1 or 2, characterized in that comparators, transistors or Schmitt triggers are used as signal shapers (CP).

## Revendications

1. Dispositif pour interroger des éléments (S) de commande d'un appareil électrique, qui sont rassemblés en groupes d'éléments de commande, dans lequel par une manoeuvre d'un élément (S) de commande un signal caractéristique de l'élément de commande correspondant est créé sous la forme d'une chute de tension dans un réseau de résistances (R) qui est quantifiée au moyen d'un convertisseur analogique-numérique (AD) et est analysée par une unité de commande (ST), et où le signal créé par les éléments (S) de commande de chaque groupe d'éléments de commande est appliqué à un dispositif (CP1, CP2) de mise en forme de signal, et les signaux des groupes d'éléments de commande sont envoyés au convertisseur analogique-numérique (AD) par l'intermédiaire d'une résistance (Rx), d'une diode ou d'un diviseur de tension correspondants,
caractérisé en ce que
des signaux de sortie du dispositif (CP1, CP2) de mise en forme de signal sont envoyés à une entrée correspondante (I1, I2) de l'unité de commande (ST), que les réseaux de résistances (R) et les éléments (S) de commande sont disposés dans une partie de commande, et que l'unité de commande (ST), le convertisseur analogique-numérique (AD) et le dispositif (CP) de mise en forme de signal sont disposés dans une partie principale de l'appareil électrique, afin qu'une nombre minimal de conducteurs de Liaison soient nécessaires entre la partie de commande et la partie principale et que les valeurs des résistances du réseau de résistances (R) soient identiques.

2. Dispositif selon la revendication 1,
caractérisé en ce que l'unité de commande (ST) est un microprocesseur muni d'au moins une entrée d'interruption (I) et au moins d'un convertisseur analogique-numérique (AD) intégré.

3. Dispositif selon les revendications 1 ou 2,
caractérisé en ce que les dispositifs de mise en forme de signaux (CP) sont réalisés à l'aide de comparateurs, transistors ou un Schmitt-Trigger.
